# EUROPEAN PATENT APPLICATION

(11) **EP 4 700 352 A1**
(43) Date of publication of application: **25.02.2026**
(21) Application number: 25197596.7
(22) Date of filing: 22.08.2025
(51) Int. Cl.: G01L 1/24, G01B 11/16, G01M 5/00, G01N 3/06, H10N 35/00, H10N 39/00

(54) **FORCE SENSOR UTILIZING MAGNETIC ELASTOMER**

(30) Priority: 22.08.2024 US 202418811803
(71) Applicant: ContiTech Deutschland GmbH, 30175 Hannover (DE)
(72) Inventor: Jing, Wuming, Auburn Hills, 48326 (US); Deniau, Jean-Christophe, Auburn Hills, 48326 (US)
(74) Representative: Preusser, Andrea

(57) **Abstract**

A system may include a magnetic sensing elastomer. A system may include a rigid frame connected to the magnetic sensing elastomer. A system may include the magnetic sensing elastomer having a first end, a magneto-rheological elastomer (MRE) link and a second end; and wherein the magnetic sensing elastomer is configured to deflect in a direction by an amount based on an applied magnetic field and properties of a sample.

## Description

### FIELD

The field to which the disclosure relates is force sensors.

### BACKGROUND

Force sensors measure an amount of force applied to an object, such as an elastomeric article. Typically, force sensors measure a force and convert the measured force into an electrical signal. This signal can then be transmitted and the like and then converted into a force measurement.

Force sensors are used in industrial applications, such as industrial automation. The force sensors can measure impact, weight, stress, feedback, deformation and the like.

However, it is appreciated that force sensors generally require power sources and electrical data connections. These result in added complexity and cost.

One or more embodiments are disclosed that provide force sensors that operate untethered without power and/or cabled data acquisition.

### BRIEF DESCRIPTION OF THE DRAWINGS

Fig. 1 is a diagram illustrating a vision-based mechanical property sensor 100 in accordance with one or more embodiments.
Fig. 2 is a diagram illustrating a vision-based mechanical property sensor system 200 for a hose 206 in accordance with one or more embodiments.
Fig. 3 is a diagram illustrating a vision-based mechanical property sensor system 300 for a conveyor belt in accordance with one or more embodiments.
Fig. 4 is a diagram illustrating the necessary components of a vision-based mechanical property sensor system: the vision system 400 and the compliant sensor structure(s) 100, that is set against the object to be measured 106 in accordance with one or more embodiments.

### DETAILED DESCRIPTION

The following description of the variations is merely illustrative in nature and is in no way intended to limit the scope of the disclosure, its application, or uses. The description is presented herein solely for the purpose of illustrating the various embodiments of the disclosure and should not be construed as a limitation to the scope and applicability of the disclosure. In the summary of the disclosure and this detailed description, each numerical value should be read once as modified by the term "about" (unless already expressly so modified), and then read again as not so modified unless otherwise indicated in context. Also, in the summary of the disclosure and this detailed description, with the understanding that a value range listed or described as being useful, suitable, or the like, is intended that any and every value within the range, including the end points, is to be considered as having been stated. For example, "a range of from 1 to 10" is to be read as indicating each and every possible number along the continuum between about 1 and about 10. Thus, even if specific data points within the range, or even no data points within the range, are explicitly identified or refer to only a few specific data points, it is to be understood that inventors appreciate and understand that any and all data points within the range are to be considered to have been specified, and that inventors had possession of the entire range and all points within the range.

Unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of the "a" or "an" are employed to describe elements and components of the embodiments herein. This is done merely for convenience and to give a general sense of concepts according to the disclosure. This description should be read to include one or at least one, and the singular also includes the plural unless otherwise stated.

The terminology and phraseology used herein is for descriptive purposes and should not be construed as limiting in scope. Language such as "including", "comprising", "having", "containing", or "involving", and variations thereof, is intended to be broad and encompass the subject matter listed thereafter, equivalents, and additional subject matter not recited.

Also, as used herein, any references to "one embodiment" or "an embodiment" means that a particular element, feature, structure, or characteristic described in connection with the embodiment is included in at least one embodiment. The appearances of the phrase "in one embodiment" in various places in the specification are not necessarily referring to the same embodiment.

Force sensors measure an amount of force applied to an object, such as an elastomeric article. Typically, force sensors measure a force and convert the measured force into an electrical signal. This signal can then be transmitted and the like and then converted into a force measurement.

Force sensors are used in industrial applications, such as industrial automation. The force sensors can measure impact, weight, stress, feedback, deformation and the like.

However, it is appreciated that force sensors generally require power sources and electrical data connections. These result in added complexity and cost.

One or more embodiments are disclosed that provide force sensors that operate untethered without power and/or data connections.

In some aspects, the techniques described herein relate to a mechanical property sensor including: a sensing structure of magnetic elastomer; a rigid frame connected to the magnetic elastomer structure; the structure having a first end, a link with soft magnetic property, and a second end; and wherein the compliant sensing structure is configured to deflect in a direction by an amount based on an applied magnetic field and mechanical properties of a sample. In one example, the structure includes a magneto-rheological elastomer (MRE).

In some aspects, the techniques described herein relate to a sensor, the magnetic elastomer including polymer and magnetic particles.

In some aspects, the techniques described herein relate to a sensor, the first end and the second end attached to a sample.

In some aspects, the techniques described herein relate to a sensor, the magnetic link attached to the rigid frame.

In some aspects, the techniques described herein relate to a sensor, the rigid frame attached to an inner surface of an elastomeric body.

In some aspects, the techniques described herein relate to a sensor, the magnetic elastomer including an elastomer matrix and magnetic particles.

In some aspects, the techniques described herein relate to a sensor, the elastomer matrix including one or more of silicon, rubber, resin and other different types of synthetic polymers.

In some aspects, the techniques described herein relate to a sensor, the magnetic particles including one or more of iron, cobalt, nickel and soft ferrites.

In some aspects, the techniques described herein relate to a sensor, wherein the magnetic elastomer is formed on a substrate of an elastomeric article.

In some aspects, the techniques described herein relate to a mechanical property sensor system including: one or more mechanical property sensors including a magnetic elastomer; a deflection detection system configured to measure one or more deflections of a sample in response to an electromagnetic field; and one or more processors configured to determine one or more sample properties based on the measured one or more deflections.

In some aspects, the techniques described herein relate to a system, wherein the deflection detection system includes an optical camera.

In some aspects, the techniques described herein relate to a system, the one or more mechanical property sensors including a link attached to a rigid frame.

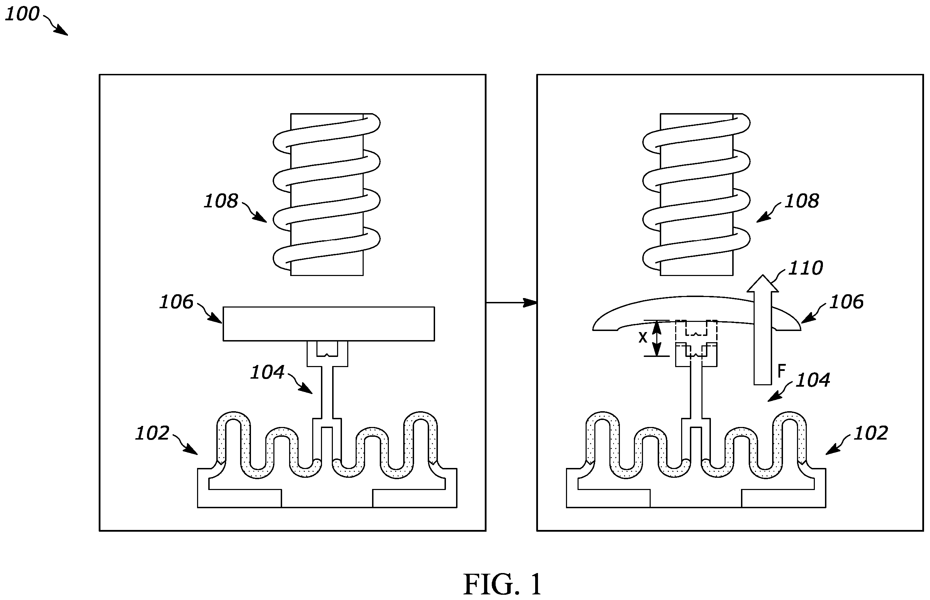

Fig. 1 is a diagram illustrating a vision-based mechanical property sensor 100 in accordance with one or more embodiments. The system is provided for illustrative purposes and suitable variations are contemplated.

The sensor 100 includes a compliant structure of magnetic elastomer 102 and a rigid frame 104.

The rigid frame 104 comprises a material that does not deform or change shape in the presence of a magnetic field. Examples of suitable materials include nonmagnetic stainless steel, plastic, glass, aluminum, brass and the like.

The magnetic sensor elastomer 102 has a first end and a second end attached to a base or substrate. The base can be a layer of an article, such as an elastomeric article. The sensing elastomer 102 also includes a link about its middle attached to the rigid frame 104. The link is between the first end and the second end.

The system 100 operates on a sample 106 in response to a force F applied by an electromagnetic source 108, such as an electromagnet coil. The sensing elastomer 102 comprises a magnetic elastomer material that moves in response to the force F. The sample 106 is a portion of an article to be measured, such as an elastomeric article.

The magnetic elastomer material can comprise composite materials including elastic properties of a polymer with magnetic particles to provide mechanical and/or magnetic properties. The physical and/or mechanical properties are altered upon the application of the electromagnetic field F. The composite materials include an elastomer matrix with magnetic particles. The elastomer matrix can include elastomers such as silicon rubber, natural rubber, polyurethane and the like. The magnetic particles include ferromagnetic materials such as iron, cobalt, nickel, ferrites and the like.

The magnetic elastomer is comprised to provide selected properties including, but not limited to, stiffness, elasticity, and magnetic response.

The force F causes the sensing elastomer 102 to deforman amount, which causes the frame 104 to move or push against the sample 106(in Fig. 1).

There is a deflection x induced by force F. The amount of x is based on the mechanical properties of both the sample 106 and sensing structure 102. For example, given the same amount of force F and know stiffness of sensing structure102, a stiffer sample 106 yields lower deflection x.

The sample 106 can include an elastomeric article, such as a conveyor belt, tire, hose, and the like.

The deflection can be measured using a suitable vision mechanism 412, such as an optical camera, and the like.

One or more sample or article properties are determined based on the measured deflection. The one or more properties include tenacity (MPa), elongation values (percentages), hardness (Shore A), and the like.

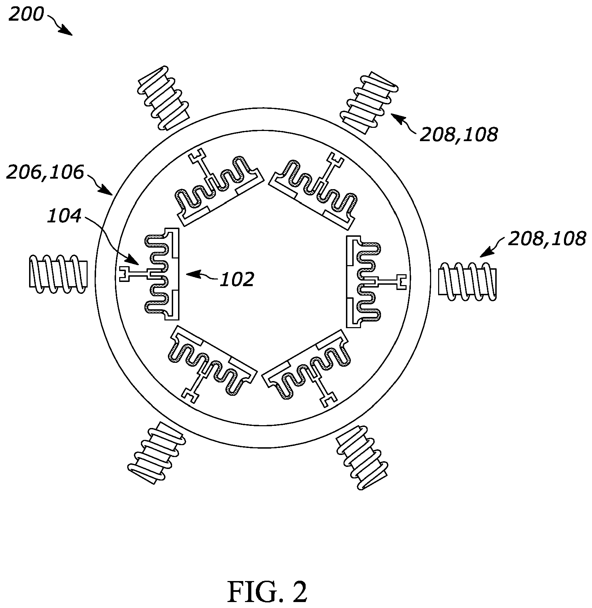

Fig. 2 is a diagram illustrating a vision-based mechanical property sensor system 200 for a hose 206 in accordance with one or more embodiments. The system is provided for illustrative purposes and suitable variations are contemplated.

The system 200 comprises a plurality of force sensors 208 and operate on an elastomeric hose 206 as the sample 106. The plurality of force sensors 208 can comprise a plurality of sensors 100.

An outward directed electromagnetic field F2 causes a plurality of deflections in the hose 206.

The deflections are measured and used to determine one or more properties of the hose 206.

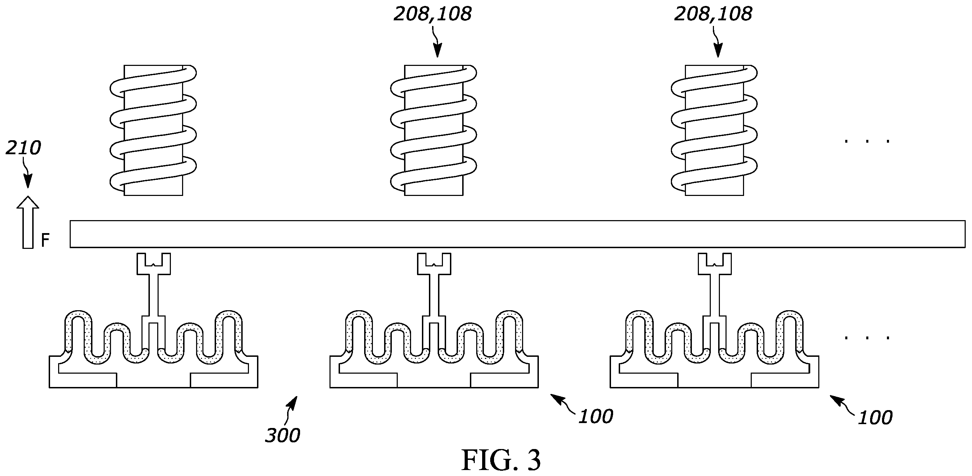

Fig. 3 is a diagram illustrating a vision-based mechanical property sensor system 300 for a hose conveyor belt in accordance with one or more embodiments. The system is provided for illustrative purposes and suitable variations are contemplated.

The system 300 comprises a plurality of force sensors 100 and operate on a conveyor belt as the sample 106.

An electromagnetic field shown as F causes a plurality of corresponding deflections in the conveyor belt.

The deflections are measured and used to determine one or more properties of the conveyor belt.

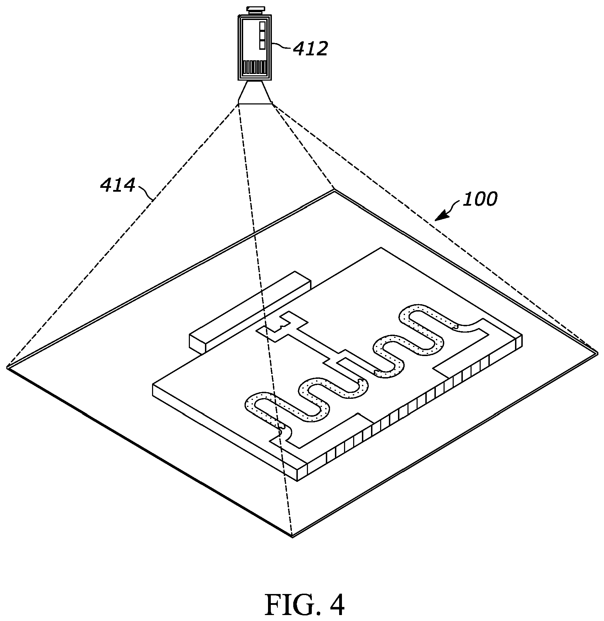

Fig. 4 is a diagram illustrating a vision-based mechanical property sensor system 400 in accordance with one or more embodiments. The system is provided for illustrative purposes and suitable variations are contemplated.

The system 400 includes at least one vision-based mechanical property sensor 100 that is set up against the testing sample 106.

The sensor 100 causes a deflection in the sample based on the sample properties and an applied electromagnetic field F.

The sensing mechanism 412 in this example is an optical camera having a suitable resolution and a field of view 414.

One or more processors 416 obtain the measured deflection from the image and determine one or more properties of the sample.

It is appreciated that other untethered sensing mechanisms can be employed, as described above.

The foregoing description of the embodiments has been provided for purposes of illustration and description. Example embodiments are provided so that this disclosure will be sufficiently thorough and will convey the scope to those who are skilled in the art. Numerous specific details are set forth such as examples of specific components, devices, and methods, to provide a thorough understanding of embodiments of the disclosure but are not intended to be exhaustive or to limit the disclosure. It will be appreciated that it is within the scope of the disclosure that individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

Also, in some example embodiments, well-known processes, well-known device structures, and well-known technologies are not described in detail. Further, it will be readily apparent to those of skill in the art that in the design, manufacture, and operation of apparatus to achieve that described in the disclosure, variations in apparatus design, construction, condition, erosion of components, gaps between components may present, for example.

Examples can include subject matter such as a method, means for performing acts or blocks of the method, at least one machine-readable medium including instructions that, when performed by a machine cause the machine to perform acts of the method or of an apparatus or system for concurrent communication using multiple communication technologies according to embodiments and examples described herein.

As used herein, the term "circuitry" may refer to, be part of, or include an Application Specific Integrated Circuit (ASIC), an electronic circuit, a processor (shared, dedicated, or group), and/or memory (shared, dedicated, or group) that execute one or more software or firmware programs, a combinational logic circuit, and/or other suitable hardware components that provide the described functionality. In some embodiments, the circuitry may be implemented in, or functions associated with the circuitry may be implemented by, one or more software or firmware modules. In some embodiments, circuitry may include logic, at least partially operable in hardware.

As it is employed in the subject specification, the term "processor" can refer to substantially any computing processing unit or device including, but not limited to including, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an Application Specific Integrated Circuit, a Digital Signal Processor, a Field Programmable Gate Array, a Programmable Logic Controller, a Complex Programmable Logic Device, a discrete gate or transistor logic, discrete hardware components, or any combination thereof designed to perform the functions and/or processes described herein. Processors can exploit nano-scale architectures such as, but not limited to, molecular and quantum-dot based transistors, switches and gates, in order to optimize space usage or enhance performance of mobile devices. A processor may also be implemented as a combination of computing processing units.

Although the terms first, second, third, etc. may be used herein to describe various elements, components, regions, layers and/or sections, these elements, components, regions, layers and/or sections should not be limited by these terms. These terms may be only used to distinguish one element, component, region, layer or section from another region, layer or section. Terms such as "first", "second", and other numerical terms when used herein do not imply a sequence or order unless clearly indicated by the context. Thus, a first element, component, region, layer or section discussed below could be termed a second element, component, region, layer or section without departing from the teachings of the example embodiments. Spatially relative terms, such as "inner", "adjacent", "outer", "beneath", "below", "lower", "above", "upper", and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

Although a few embodiments of the disclosure have been described in detail above, those of ordinary skill in the art will readily appreciate that many modifications are possible without materially departing from the teachings of this disclosure. Accordingly, such modifications are intended to be included within the scope of this disclosure as defined in the claims.

## Claims

1. A mechanical property sensor comprising:
a sensing structure of magnetic elastomer;
a rigid frame connected to the magnetic elastomer;
the magnetic sensing elastomer having a first end, a magneto-rheological elastomer (MRE) link and a second end; and
wherein the magnetic sensing elastomer is configured to deflect in a direction by an amount based on an applied magnetic field and properties of a sample.

2. The sensor of claim 1, the magnetic elastomer comprising polymer.

3. The sensor of claim 2, the magnetic elastomer comprising magnetic particles.

4. The sensor of claim 1, the magnetic elastomer link attached to the rigid frame.

5. The sensor of claim 1, another part of rigid frame serving as end-effector set up against an inner surface of an elastomeric layer of a sample.

6. The sensor of claim 1, the sensing structure of magnetic elastomer comprising an elastomer matrix and magnetic particles.

7. The sensor of claim 6, the elastomer matrix comprising one or more links made comprising polymer.

8. The sensor of claim 7, the magnetic particles comprising one or more of iron, cobalt, nickel and ferrites with soft magnetic property.

9. The sensor of claim 1, wherein the magnetic elastomer is formed on a substrate of an elastomeric article.

10. A mechanical property sensor system comprising:
one or more mechanical property sensors comprising a magnetic sensing elastomer;
a vision-based deflection detection system configured to measure one or more deflections of a sample in response to an electromagnetic field; and
one or more processors configured to determine one or more sample properties based on the measured one or more deflections.

11. The system of claim 10, wherein the deflection detection system comprises one or more optical cameras.

12. The system of claim 10, the array of one or more mechanical property sensors comprising a link attached to a rigid frame.
